# EUROPEAN PATENT APPLICATION

(11) **EP 4 546 499 A1**
(43) Date of publication of application: **30.04.2025**
(21) Application number: 23829520.8
(22) Date of filing: 22.03.2023
(51) Int. Cl.: H01M 10/42, H01M 10/48, G01R 31/36

(54) **BATTERY MANAGEMENT CHIP AND SYSTEM, AND VEHICLE**

(30) Priority: 30.06.2022 CN 202210756825
(71) Applicant: BYD Company Limited, Shenzhen, Guangdong 518118 (CN)
(72) Inventor: XIE, Xike, Shenzhen, Guangdong 518118 (CN); LI, Jie, Shenzhen, Guangdong 518118 (CN); LI, Qifeng, Shenzhen, Guangdong 518118 (CN); YANG, Yun, Shenzhen, Guangdong 518118 (CN)
(74) Representative: Taor, Simon Edward William
(86) International application number: PCT/CN2023/083079
(87) International publication number: WO 2024/001329

(57) **Abstract**

A vehicle, includes a battery management chip and a battery management system. The battery management chip comprises a battery cell data sampling module, a data processing module, a first communication module and a first power source module. The battery cell data sampling module is used for acquiring battery cell data of a battery cell; the data processing module is connected to the battery cell data sampling module, and is used for processing the battery cell data; the first communication module is connected to the data processing module, and is used for sending the processed battery cell data to a control module; and the first power source module is connected to the battery cell and the data processing module, and is used for receiving an initial voltage outputted by the battery cell, and performing boost processing on the initial voltage, so as to provide an operating voltage for the data processing module.

## Description

### CROSS-REFERENCE TO RELATED APPLICATIONS

The present disclosure claims priority to Chinese Patent Application No. 202210756825.0 filed on June 30, 2022 and entitled "BATTERY MANAGEMENT CHIP AND SYSTEM, AND VEHICLE ", which is incorporated herein by reference in its entirety.

### FIELD

The present disclosure relates to the field of vehicle technologies, and in particular, to a battery management chip and system, and vehicle.

### BACKGROUND

The Battery Management System (BMS) mainly acquires the voltage, current, temperature, dynamic internal resistance and other data of the battery pack, and transmits the data with the upper control module by using the traditional wiring harness communication mode to realize the interactive control of data transmission.

Currently, a battery pack consisting of multiple battery cells is monitored by a battery management chip. The high voltage of the battery pack poses a great challenge to the process and safety of the battery management chip. Secondly, the normal operation of the battery management chip involves low voltage, in order to ensure the consistency of all the electrical quantities of the battery cells in the battery pack, it is necessary to take power from the total voltage, and get the voltage that the chip can use after step-down treatment, which will increase the unnecessary energy loss of the battery cell. In addition, a battery management chip monitors multiple battery cells at the same time, and there is a risk of chip failure during the long-term operation of the vehicle, resulting in the loss of cell data of multiple battery cells, increasing the failure rate of the vehicle. Finally, multiple battery cells are monitored by a management chip, which will use complex sampling wiring harness and connectors, while the design of the sampling board of the battery management chip will become complicated, on the one hand will lead to a sharp rise in cost, on the other hand, the stability and reliability of the harness connectors will increase the failure rate of the vehicle, at the same time, The electronic power technology boost circuit cannot guarantee the normal operation of the chip under a wide range of low voltages.

### SUMMARY

The present disclosure is intended to resolve one of technical problems in the related art at least to some extent.

Therefore, the first object of the present disclosure is to propose a battery management chip, which provides an operating voltage for a data processing module by disposing a first power supply module to boost the initial voltage output by a battery cell, ensures that the battery management chip can operate in a wide range of low voltage, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

Therefore, the second object of the present disclosure is to propose a battery management system.

Therefore, the third object of the present disclosure is to propose a vehicle.

In order to achieve the above objects, embodiments of the first aspect of the present disclosure proposes a battery management chip being correspondingly connected to a single battery cell, the battery management chip includes: a battery cell data sampling module for acquiring battery cell data of the battery cell; a data processing module connected to the battery cell data sampling module and used for processing the battery cell data; a first communication module connected to the data processing module and used for transmitting the processed battery cell data to a control module; a first power module connected to the battery cell and the data processing module and used for receiving an initial voltage output by the battery cell and performing boost processing on the initial voltage to provide an operating voltage for the data processing module.

The battery management chip according to an embodiment of the present disclosure, boosts the initial voltage output by the battery cell through the first power module, provides an operating voltage for the data processing module, ensures that the battery management chip can operate in a wide range of low voltages, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

In some embodiments, the first power module includes a boost circuit unit connected to the battery cell and used for performing boost processing on an initial voltage output by the battery cell to output an initial target voltage.

In some embodiments, the first power module further includes an input filtering voltage stabilizing circuit unit, an input terminal thereof being connected to a voltage output terminal of the battery cell and being used for reducing voltage ripple interference of the initial voltage output by the battery cell to output a DC voltage.

In some embodiments, the first power module further includes an output filtering voltage stabilizing circuit unit connected to the boost circuit unit, used for performing filtering and voltage stabilizing process on the initial target voltage to obtain a target voltage, and outputting the target voltage to provide an operating voltage for the data processing module.

In some embodiments, the first power module further includes a sampling feedback unit connected to the output filtering voltage stabilizing circuit unit and the boost circuit unit, respectively, and used for acquiring a voltage value of the target voltage and feeding back the voltage value of the target voltage to the boost circuit unit.

In some embodiments, the boosting circuit unit is further configured to receive the voltage value of the target voltage and adjust a boost action based on the voltage value of the target voltage, so that the initial target voltage of adjusted output is filtered and stabilized by output filtering voltage stabilizing circuit unit (132) to output the target voltage in preset voltage range.

In some embodiments, the boost circuit unit includes: a PWM generating circuit subunit, a first terminal thereof being connected to an output terminal of the input filtering voltage stabilizing circuit unit, a second terminal thereof being grounded, and a third terminal thereof being used for outputting a PWM (Pulse Width Modulation technique) signal; a charge pump boost subunit, a first terminal thereof being connected to the third terminal of the PWM generating circuit subunit, and being used for adjusting the frequency and duty cycle of the PWM signal in real time until the initial target voltage is obtained.

In some embodiments, the PWM generating circuit subunit includes: an energy storage subunit, one terminal thereof being connected to the output terminal of the input filtering voltage stabilizing circuit unit, and the other terminal of the which is grounded; a waveform generating subunit, a first terminal thereof being connected to the output terminal of the input filtering voltage stabilizing circuit unit, and a second terminal thereof being grounded; a voltage follower circuit, a first terminal thereof being connected to the output terminal of the input filtering voltage stabilizing circuit unit, and third terminal thereof being grounded; a first comparator, a positive-phase input terminal thereof being connected to the first terminal of the waveform generating subunit; a second comparator, a positive-phase input terminal thereof being connected to the third terminal of the voltage follower circuit, an inverting input terminal thereof being connected to an inverting input terminal of the first comparator, and an output terminal thereof being connected to the first terminal of the charge pump boost subunit; a charge/discharge capacitor, one terminal thereof being connected to the inverting input terminal of the first comparator and the inverting input terminal of the second comparator, and the other terminal thereof being grounded; a duty cycle adjustment resistor, one terminal thereof being connected to the output terminal of the input filtering voltage stabilizing circuit unit, and the other terminal thereof being connected to a second terminal of the voltage follower circuit.

In some embodiments, the waveform generating subunit includes: a voltage adjusting subunit, a first terminal thereof being connected to the output terminal of the input filtering voltage adjusting circuit unit, and a second terminal thereof being grounded; a charge/discharge subunit, one terminal thereof being connected to an output terminal of the first comparator, and the other terminal thereof being connected to one terminal of the charge/discharge capacitor.

In some embodiments, the voltage adjusting subunit includes: a first resistor, one terminal thereof being connected to the output terminal of the input filtering voltage adjusting circuit unit; a second resistor, one terminal thereof being connected to the output terminal of the input filtering voltage stabilizing circuit unit; a third resistor, one terminal thereof being connected to the other terminal of the first resistor and the other terminal thereof being connected to the other terminal of the second resistor; a fourth resistor, one terminal of the fourth resistor is connected to the positive-phase input terminal of the first comparator, and the other terminal of the fourth resistor is grounded.

In some embodiments, the charge/discharge subunit includes: a fifth resistor.

In some embodiments, the voltage follower circuit includes: a voltage dividing subunit, one terminal thereof being connected to the other terminal of the duty cycle adjustment resistor, and the other terminal thereof being grounded; a voltage difference output unit, a first terminal thereof being connected with the output terminal of the input filtering voltage stabilizing circuit unit, and a second terminal thereof being connected with one terminal of the voltage dividing subunit.

In some embodiments, the voltage difference output unit includes: a seventh resistor, one terminal thereof being connected to one terminal of the duty cycle adjustment resistor; a triode, a base electrode of the triode is connected to the other terminal of the duty cycle adjustment resistor, and a collector electrode of the triode is connected to the other terminal of the seventh resistor; a voltage stabilizing energy storage capacitor, one terminal thereof being connected to an emitter electrode of the triode, and the other terminal thereof being grounded.

In some embodiments, the charge pump boost subunit includes: a filtering voltage stabilizing capacitor, one terminal thereof being connected to the output terminal of the input filtering voltage stabilizing circuit unit, and the other terminal thereof being grounded; a feedback adjusting subunit, a first terminal thereof being connected to one terminal of the filtering voltage stabilizing capacitor, and a second terminal thereof being grounded; a charge/discharge control subunit, a first terminal thereof being connected to one terminal of the filtering voltage stabilizing capacitor, and a second terminal thereof being connected to the output terminal of the second comparator; an energy storage capacitor, one terminal thereof being connected to a third terminal of the charge/discharge control subunit, and the other terminal thereof being grounded, and the energy storage capacitor being used for charging when the second switching transistor and the fourth switching transistor are turned on.

In some embodiments, the charge/discharge control subunit includes: a first switching transistor, a gate electrode thereof being connected to the output terminal of the second comparator; an inverter, an input terminal thereof being connected to the output terminal of the second comparator; a second switch transistor, a gate electrode thereof being connected to an output terminal of the inverter; a third switch transistor, a drain electrode thereof being connected to a source electrode of the second switch transistor, and a gate electrode thereof being connected to the gate electrode of the first switch transistor; a fourth switch transistor, a source electrode thereof being connected to a source electrode of the third switch transistor, and a gate of the which is connected to the output terminal of the inverter; a pump capacitor, one terminal thereof being connected to a drain electrode of the second switch transistor, and the other terminal thereof being connected to a source electrode of the fourth switch transistor, and the pump capacitor being used for charging when the first switch transistor and the third switch transistor are turned on.

In some embodiments, the feedback adjusting subunit includes: a tuning resistor, a first terminal thereof being connected to the output terminal of the input filtering voltage stabilizing circuit unit, and a second terminal thereof being connected to the first terminal of the charge/discharge control subunit; a first feedback resistor, one terminal thereof being connected to one terminal of the energy storage capacitor; a second feedback resistor, one terminal thereof being connected to the other terminal of the first feedback resistor and the other terminal thereof being grounded; an eighth resistor, one terminal thereof being connected to one terminal of the first feedback resistor and the other terminal thereof being connected to the other terminal of the second feedback resistor; a feedback comparator, an inverting input terminal thereof being connected to the other terminal of the first feedback resistor and a positive-phase input terminal thereof being connected to an output terminal of the sampling feedback unit; a logic subunit, an input terminal thereof being connected to an output terminal of the feedback comparator and an output terminal thereof being connected to an adjusting terminal of the tuning resistor.

In some embodiments, the first communication module includes a first wireless communication unit.

In some embodiments, the first power module is connected to the first wireless communication unit and is used for supplying power to the first wireless communication unit.

In some embodiments, the data processing module includes: a multiplexing switch module connected to the battery cell data sampling module and configured to select the battery cell data; a conversion module connected to the multiplexing switch module and configured to perform analog/digital or digital/analog conversion on the selected battery cell data to obtain digital information and/or analog information of the battery cell data; a filtering module connected to the conversion module and configured to filter out interference information in the digital information and/or analog information; an arithmetic storage module connected to the filtering module and configured to perform arithmetic and storage of the filtered digital information and/or analog signals.

In some embodiments, the battery cell data sampling module includes at least one of: a voltage sampling module configured to acquire voltage data of the battery cell, a current sampling module configured to acquire power data of the battery cell, a temperature acquisition module configured to acquire temperature data of the battery cell, and a resistance sampling module configured to acquire resistance data of the battery cell.

In some embodiments, the battery management chip further includes: an equalization module connected to the battery cell and configured to perform consistency processing on the voltage of the battery cell so that the difference between the voltage of the battery cell and the minimum voltage of the remaining battery cells is within a preset voltage range.

In some embodiments, the temperature acquisition module includes a temperature sensor integrally disposed in the temperature acquisition module.

In order to achieve the above object, an embodiment of the second aspect of the present disclosure proposes a battery management system. The battery management system includes: at least one battery management chip as described in the above embodiment; at least one battery cell connected to at least one of the battery management chips in one-to-one correspondence; a control module communicating with the battery management chip.

In some embodiments, the control module includes: a second communication module, which is in communication with a first communication module of the battery management chip; a micro-control unit, which receives battery cell data transmitted by the battery management chip through the second communication module, and transmits a control signal to the battery management chip through the second communication module so that the battery management chip can control the battery cells connected thereto; a second power supply module, which is connected to the micro control unit and is configured to supply power to the micro control unit.

In some embodiments, the second communication module includes a second wireless communication unit, and the second power module is connected to the second wireless communication unit and is used for supplying power to the second wireless communication unit.

In order to achieve the above object, an embodiment of the third aspect of the present disclosure provides a vehicle, which includes the battery management system described in the above embodiment.

The additional aspects and advantages of the present disclosure are partially provided in the following descriptions, some of which will become apparent from the following descriptions or may be learned from practices of the present disclosure.

### BRIEF DESCRIPTION OF THE DRAWINGS

The above and/or additional aspects and advantages of the present disclosure will become apparent and readily understood from the description of embodiments taken in conjunction with the following drawings, in which:
FIG. 1 is a block diagram of a battery management chip according to an embodiment of the present disclosure;
FIG. 2 is a block diagram of a first power module according to an embodiment of the present disclosure;
FIG. 3 is a schematic diagram of a circuit structure of a boost circuit unit according to a specific embodiment of the present disclosure;
FIG. 4 is a schematic diagram of a voltage waveform at a charge/discharge capacitor C2 according to an embodiment of the present disclosure;
FIG. 5 is a schematic diagram of a pulse waveform output by a second comparator Q2 according to an embodiment of the present disclosure;
FIG. 6 is a block diagram of communication between a battery management chip and a control module according to an embodiment of the present disclosure;
FIG. 7 is a schematic diagram of the structure of a battery management system according to an embodiment of the present disclosure;
FIG. 8 is a block diagram of a vehicle according to an embodiment of the present disclosure.

Reference numerals: battery management chip (BMC) 1; battery cell data sampling module (BCDSM) 10; data processing module (DPM) 11; first communication module (FCM) 12; first power module (FPM) 13; input filtering voltage stabilizing circuit unit (IFVSCU) 130; boost circuit unit (BCU) 131; output filtering voltage stabilizing circuit unit (OFVSCU) 132; sampling feedback unit (SFU) 133; PWM generating circuit subunit 134; charge pump boost subunit 135; waveform generating subunit 136; voltage follower circuit 137; inverter 138; logic subunit 139; multiplexing switch module (MSM) 110; conversion module (CONVM) 111; filtering module (FLTM) 112; arithmetic storage module (ASM) 113; equalization module (EQM) 14; clock module (CLKM) 15; battery management system (BMC) 2; control module (CTRLM) 21; second communication module (SCM) 22; micro-control unit (MCU) 23; second power module (SPM) 24; vehicle 3.

### DETAILED DESCRIPTION

The embodiments of the present disclosure are described below in detail, and the embodiments described with reference to the accompanying drawings are exemplary.

The battery management chip acquires the voltage data, current data, temperature data and resistance data of the battery cells, and transmits the data to the control module, so that the control module can analyze and process the data to realize the operation of the battery cells.

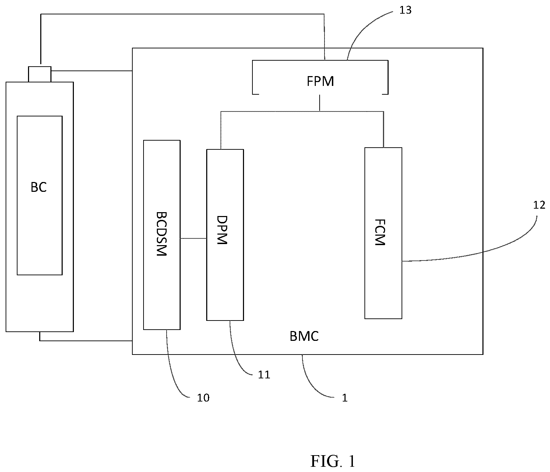

Hereinafter, a battery management chip according to an embodiment of the present disclosure will be described as an example with reference to FIGS. 1 to 4.

As shown in FIG. 1, a battery management chip 1 according to an embodiment of the present disclosure includes: a battery cell data sampling module 10, a data processing module 11, a first communication module 12, and a first power supply module 13.

The battery cell data sampling module 10 is configured to acquire battery cell data of the battery cell (BC); the data processing module 11 is connected with the battery cell data sampling module 10, and is used for processing battery cell data; the first communication module 12 is connected to the data processing module 11, and is used for transmitting the processed battery cell data to the control module; the first power module 13 is connected with the battery cell and the data processing module 11, and is used for receiving the initial voltage output by the battery cell, and performing boost processing on the initial voltage to provide an operating voltage for the data processing module 11. It can be understood that the battery management chip 1 is correspondingly connected to a single battery cell to avoid the battery cell working under high voltage, thereby avoiding the problem that the battery cell needs to be bucked to provide power to the battery management chip 1, and reducing unnecessary energy loss. Furthermore, the battery management chip is connected to a single battery cell to detect the single battery cell, which greatly reduces the risk of failure of the battery management chip during the long-term operation of the vehicle, thereby reducing the failure rate of the vehicle. Finally, since the battery management chip is connected to a single battery cell, the use of wiring harnesses and connectors can be greatly reduced, the complexity of chip design can be reduced, and the design is more flexible.

In an embodiment, when the battery management chip 1 receives a valid operation instruction, such as a voltage acquisition instruction, the battery cell data sampling module 10 acquires battery cell data of the battery cell according to the received corresponding operation instruction. Since the initial voltage of the battery cell is a wide range of low voltage signals, for example, the initial voltage of the battery cell is between 2.5 V and 5.5 V, the normal operation of the battery management chip 1 cannot be ensured, at this point, the initial voltage of the battery cell is boosted by the first power module 13, for example, the operating voltage after the boost processing is between 3.3 V and 5V, so as to provide the operating voltage for the normal operation of the data processing module 11, so that the data processing module 11 processes the battery cell data after receiving the battery cell data transmitted by the battery cell data sampling module 10, and transmits the processed battery cell data to the control module through the first communication module 12. The control module analyzes and processes the received battery cell data to issue corresponding operation instructions to the battery cell. By setting the first power module 13, the initial voltage output by the battery cell is boosted to provide the working voltage for the data processing module 11, so as the battery management chip 1 can work normally under a wide range of low voltages.

The battery management chip according to an embodiment of the present disclosure, boosts the initial voltage output by the battery cell through the first power module, provides an operating voltage for the data processing module, ensures that the battery management chip can operate in a wide range of low voltages, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

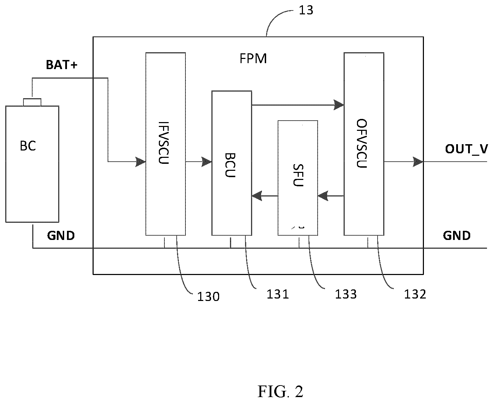

For example, FIG. 2 shows a block diagram of a first power module 13 according to an embodiment of the present disclosure. The first power supply module 13 includes: an input filtering voltage stabilizing circuit unit 130, a boost circuit unit 131, and an output filter voltage stabilizing circuit unit 132. An input terminal of the input filtering voltage stabilizing circuit unit 130 is connected to a voltage output terminal of the battery cell, and is used for reducing the voltage ripple interference of the initial voltage output by the battery cell, and outputting a DC voltage. The boosting circuit unit 131 is connected to an output terminal of the input filtering voltage stabilizing circuit unit 130, and is used for boosting the DC voltage to obtain an initial target voltage. The output filtering voltage stabilizing circuit unit 132 is connected to the boosting circuit unit 131, and is used for filtering and stabilizing the initial target voltage to obtain the target voltage, and outputting the target voltage to provide an operating voltage for the data processing module 11.

In the embodiment, the initial voltage is provided by a single battery cell, and after the single battery cell outputs the initial voltage, the input filtering voltage stabilizing circuit unit 130 receives the initial voltage and reduces the voltage ripple interference of the initial voltage to obtain a relatively stable DC voltage, and outputs the DC voltage. The output DC voltage is boosted by the boost circuit unit 131 to obtain the initial target voltage, and the initial target voltage is transmitted to the output filtering voltage stabilizing circuit unit 132. The output filtering voltage stabilizing circuit unit 132 performs filtering and stabilizing processing on the received initial target voltage to obtain the target voltage, and outputs the target voltage to the data processing module 11 to provide an operating voltage for the data processing module 11. It can be understood that the initial voltage is a wide-range low voltage, and the DC voltage, which is the initial voltage filtered out of voltage ripple interference, is processed by the boost circuit unit 131 to obtain the initial target voltage. The initial target voltage provides an operating voltage for normal operation of the battery management chip 1. The initial target voltage is stabilized and filtered to obtain a relatively stable initial target voltage, and the relatively stable initial target voltage is taken as the target voltage. The initial voltage output from the battery cell is boosted by the boosting circuit unit 131 to provide an operating voltage to the data processing module 11, and ensure that the battery management chip can operate in a wide range of low voltages.

In some embodiments, as shown in FIG. 2, the boost circuit unit 131 is integrally disposed in the first power module 13. By integrating the boost circuit unit 131 into the first power supply module 13, it is possible to save the arrangement space and reduce the cost as compared with using devices that cannot be integrated such as inductors and transformers.

In some embodiments, as shown in FIG. 2, the first power module 13 further includes a sampling feedback unit 133. The sampling feedback unit 133 is connected to the output filtering voltage stabilizing circuit unit 132 and the boost circuit unit 131, respectively, and is used for acquiring the voltage value of the target voltage and feeding back the voltage value of the target voltage to the boosting circuit unit 131. The boosting circuit unit 131 is further used for receiving the voltage value of the target voltage and adjusting the boost operation of the DC voltage based on the voltage value of the target voltage, so that the initial target voltage output after adjustment is filtered and stabilized by the output filtering stabilizing circuit unit 132, and the output target voltage is in a preset voltage range.

In an embodiment, the preset voltage range is a voltage range that ensures the normal operation of the battery management chip 1, for example, 3.3 V-5 V. After the output filtering voltage stabilizing circuit unit 132 outputs the target voltage, considering that the current consumption of the battery management chip 1 is different in different operating modes, resulting in a large change in the target voltage, at this point, the initial target voltage is detected by the sampling feedback unit 133, and the boost operation of the boost circuit unit 131 is adjusted in real time based on the voltage value of the target voltage to ensure that the output target voltage is in the preset voltage range, in other words, it is ensured that the output target voltage does not change greatly with the change of the operating mode.

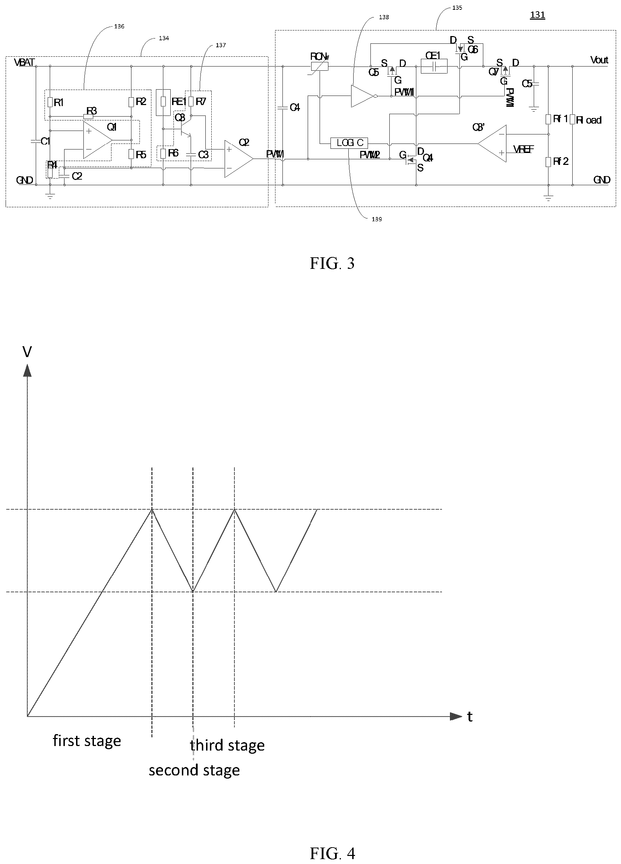

In some embodiments, FIG. 3 shows a schematic diagram of a circuit structure of a boost circuit unit 131 according to an embodiment of the present disclosure. The boost circuit unit 131 includes a PWM generating circuit subunit 134, a first terminal of the PWM generating circuit subunit 134 being connected to an output terminal of the input filtering voltage stabilizing circuit unit 130, a second terminal of the PWM generating circuit subunit 134 being grounded, and a third terminal of the PWM generating circuit subunit 134 being used for outputting a PWM signal; and a charge pump boost subunit 135, a first terminal of the charge pump boost subunit 135 being connected to the third terminal of the PWM generating circuit subunit 134, and being used for adjusting the frequency and duty cycle of the PWM signal in real time until the initial target voltage being obtained. Among them, the charge pump boosting subunit 135 adopts the principle of charge pump circuit boost and operates by charge transfer. The pump capacitor can transfer the charge from the input terminal to the output terminal to provide the current required by the load, adopts the capacitor to store energy, has no EMI interference, low noise, low cost, small quiescent current and small output voltage ripple, and can provide high current operation through feedback adjustment.

In an embodiment, a front stage of the boost circuit unit 131 is a PWM generating circuit subunit 134, and a rear stage is a charge pump boost subunit 135. The charge pump boost subunit 135 controls the frequency and duty cycle of the PWM signal. The boost circuit unit 131 continuously boosts the DC voltage through the PWM generating circuit subunit 134 and the charge pump boost subunit 135 until the initial target voltage is obtained.

In some embodiments, as shown in FIG. 3, the PWM generating circuit subunit 134 includes an energy storage subunit C1, a waveform generating subunit 136, a voltage follower circuit 137, a first comparator Q1, a second comparator Q2, a charge/discharge capacitor C2, and a duty cycle adjustment resistor RE1. Among them, one terminal of the energy storage subunit C1 is connected to the output terminal of the input filtering voltage stabilizing circuit unit 130, and the other terminal of the energy storage sub-unit C1 is grounded. A first terminal of the waveform generating subunit 136 is connected to the output terminal of the input filtering voltage stabilizing circuit unit 130, and the second terminal of the waveform generating subunit 136 is grounded. A first terminal of the voltage follower circuit 137 is connected to the output terminal of the input filtering voltage stabilizing circuit unit 130, and a third terminal of the voltage follower circuit 137 is grounded. A positive-phase input terminal of the first comparator Q1 is connected to the first terminal of the waveform generating subunit 136. A positive-phase input terminal of the second comparator Q2 is connected to the third terminal of the voltage follower circuit 137, an inverting input terminal of the second comparator Q2 is connected to an inverting input terminal of the first comparator Q1, and an output terminal of the second comparator Q2 is connected to the first terminal of the charge pump boost subunit 135. One terminal of the charge/discharge capacitor C2 is connected to the inverting input terminal of the first comparator Q1 and the inverting input terminal of the second comparator Q2, and the other terminal of the charge/discharge capacitor C2 is grounded. One terminal of the duty cycle adjustment resistor RE1 is connected to the output terminal of the input filtering voltage stabilizing circuit unit 130, and the other terminal of the duty cycle adjustment resistor RE1 is connected to a second terminal of the voltage follower circuit 137.

In the embodiment, the charge/discharge capacitor C2 and the first comparator Q1 in the PWM generation circuit subunit 134 output a sawtooth wave, and the duty cycle adjustment resistor RE1 is adjusted to output a PWM signal for use by the subsequent circuit via the voltage follower circuit 137 and the second comparator Q2.

For example, as shown in FIG. 3, the waveform generating subunit 136 includes a voltage adjusting subunit and a charging/discharging subunit. The voltage adjusting subunit includes a first resistor R1, a second resistor R2, a third resistor R3, and a fourth resistor R4. The charge/discharge subunit includes a fifth resistor R5. One terminal of the first resistor R1 is connected to the output terminal of the input filtering voltage stabilizing circuit unit 130. One terminal of the second resistor R2 is connected to the output terminal of the input filtering voltage stabilizing circuit unit 130. One terminal of the third resistor R3 is connected to the other terminal of the first resistor R1, and the other terminal of the third resistor R3 is connected to the other terminal of the second resistor R2. One terminal of the fourth resistor R4 is connected to the positive-phase input terminal of the first comparator Q1, and the other terminal of the fourth resistor R4 is grounded. One terminal of the fifth resistor R5 is connected to the output terminal of the first comparator Q1, and the other terminal of the fifth resistor R5 is connected to one terminal of the charge/discharge capacitor C2.

It is understood that the PWM generating circuit subunit 134 may be divided into three stages when outputting the PWM pulse waveform. In the first stage, the voltage at the inverting input terminal of the first comparator Q1 is 0, and the voltage at the positive-phase input terminal is R4 * VBAT/(R4 + ((R2+R3)//R1)). At this point, the first comparator Q1 outputs a high level and charges the charging/discharging capacitor C2 through the fifth resistor R5; In the second stage, when the charging voltage of the charging/discharging capacitor C2 reaches the voltage of the positive-phase input terminal of the first comparator Q1, that is, reaches R4 * VBAT/(R4 + ((R2+R3)//R1)), the first comparator Q1 outputs a low level, and the voltage at the positive-phase input terminal of the first comparator Q1 is (R3//R4) * VBAT/((R3//R4) + R1), and the charging/discharging capacitor C2 is discharged through the fifth resistor R5; In the third stage, when the voltage discharged by the charge/discharge capacitor C2 to the positive-phase input terminal of the first comparator Q1 is lower than (R3//R4) * VBAT/((R3//R4) + R1), the first comparator Q1 outputs a high level and returns to the first stage again, thereby realizing the output PWM pulse waveform.

FIG. 4 is a schematic diagram of a voltage waveform at a charge/discharge capacitor C2 according to an embodiment of the present disclosure. As can be seen from FIG. 4, the waveform at the charge and discharge capacitance C2 is different at different stages.

In some embodiments, as shown in FIG. 3, the voltage follower circuit 137 includes a voltage dividing subunit and a voltage differential output unit. One terminal of the voltage dividing subunit is connected to the other terminal of the duty cycle adjustment resistor RE1, and the other terminal of the voltage dividing subunit is grounded. Specifically, the voltage dividing subunit includes a sixth resistor, and the voltage difference output unit includes a triode Q3, a seventh resistor R7, and a voltage stabilizing energy storage capacitor C3. One terminal of the seventh resistor R7 is connected to one terminal of the duty adjustment resistor RE1. A base electrode of the triode Q3 is connected to the other terminal of the duty adjustment resistor RE1, and a collector electrode of the triode Q3 is connected to the other terminal of the seventh resistor R7. One terminal of the voltage stabilizing energy storage capacitor C3 is connected with a emitter electrode of the triode Q3, and the other terminal of the voltage stabilizing energy storage capacitor C3 is grounded.

In the embodiment, the duty cycle adjusting resistor RE1 is an adjustable resistor, and the duty cycle adjusting resistor RE1 and the sixth resistor R6 are connected in series to realize the voltage adjustment of the base electrode of the triode Q3, the voltage of the voltage stabilizing energy storage capacitor C3 will change according to the change of the voltage of the base electrode of the triode Q3, and the voltage at the positive-phase input terminal of the second comparator Q2 is R6 * VBAT/(R6 + RE1-0. 7V), among them, the seventh resistor R7 provides the load capacity for the triode Q3. It is understood that the carrying capacity is the magnitude of the output resistance in the circuit.

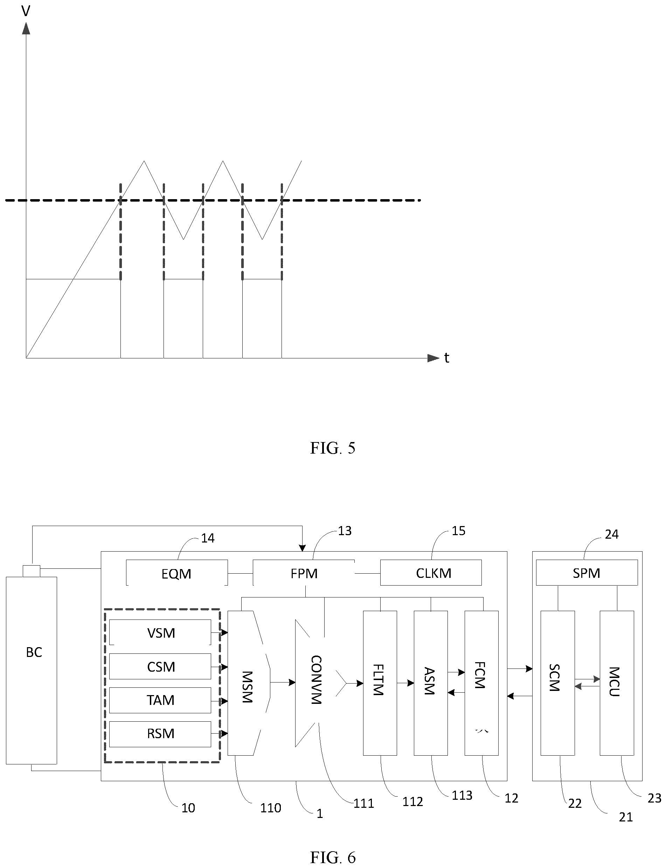

FIG. 5 is a schematic diagram of a pulse waveform output by a second comparator Q2 according to an embodiment of the present disclosure. As can be seen from FIG. 5, the second comparator Q2 outputs a PWM waveform, and the duty cycle of the PWM waveform is adjusted by adjusting the duty cycle adjustment resistor RE1.

In some embodiments, as shown in FIG. 3, the charge pump boost subunit includes a filtering voltage stabilizing capacitor C4, a feedback adjusting subunit, a charge/discharge control subunit, and an energy storage capacitor C5. One terminal of the filtering voltage stabilizing capacitor C4 is connected to the output terminal of the input filtering voltage stabilizing circuit unit 130, and the other terminal of the filter voltage stabilizing capacitor C4 is grounded. A first terminal of the feedback adjusting subunit is connected to one terminal of the filtering voltage stabilizing capacitor C4, and a second terminal of the feedback adjusting subunit is grounded. A first terminal of the charge/discharge control subunit is connected with one terminal of the filtering voltage stabilizing capacitor C4, and the second terminal of the charge/discharge control subunit is connected with the output terminal of the second comparator Q2. One terminal of the energy storage capacitor C5 is connected to a third terminal of the charge/discharge control subunit and the other terminal of the energy storage capacitor C5 is grounded, and the energy storage capacitor C5 is used for charging when a second switch transistor Q5 and a fourth switch transistor Q7 are turned on.

Among them, the charge/discharge control subunit includes a first switch transistor Q4, an inverter 138, a second switch transistor Q5, a third switch transistor Q6, a fourth switch transistor Q7, and a pump capacitor CE1. The feedback adjusting subunit includes a tuning resistor RON, a first feedback resistor Rf1, a second feedback resistor Rf2, a feedback comparator Q3', an eighth resistor Rload, and a logic subunit 139. Specifically, a gate electrode of the first switch transistor Q4 is connected to the output terminal of the second comparator Q2; an input terminal of the inverter 138 is connected to the output terminal of the second comparator Q2; a gate electrode of the second switch transistor Q5 is connected to an output terminal of the inverter 138; a drain electrode of the third switch transistor Q6 is connected to a source electrode of the second switch transistor Q5, and a gate electrode of the third switch transistor Q6 is connected to the gate of the first switch transistor Q4; a source electrode of the fourth switch transistor Q7 is connected to a source electrode of the third switch transistor Q6, and a gate electrode of the fourth switch transistor Q7 is connected to the output terminal of the inverter 138; one terminal of the pump capacitor is connected to the drain electrode of the second switch transistor Q5, and the other terminal of the pump capacitor CE1 is connected to the source of the fourth switch transistor Q7, and the pump capacitor is used for charging when the first switch transistor Q4 and the third switch transistor Q6 are turned on. A first terminal of the tuning resistor RON is connected to the output terminal of the input filtering voltage stabilizing circuit unit 130, and a second terminal of the tuning resistor RON is connected to the first terminal of the charge/discharge control subunit; one terminal of the first feedback resistor Rf1 is connected to one terminal of the energy storage capacitor C5; one terminal of the second feedback resistor Rf2 is connected to the other terminal of the first feedback resistor Rf1, and the other terminal of the second feedback resistor Rf2 is grounded; one terminal of the eighth resistor Rload is connected to one terminal of the first feedback resistor, and the other terminal of the eighth resistor Rload is connected to the other terminal of the second feedback resistor Rf2; an inverting input terminal of the feedback comparator Q3 'is connected to the other terminal of the first feedback resistor Rf1, and a positive-phase input terminal of the feedback comparator Q3' is connected to an output terminal of the sampling feedback unit 133; an input terminal of the logic subunit 139 is connected to an output terminal of the feedback comparator Q3 ', and an output terminal of the logic subunit 139 is connected to a adjusting terminal of the tuning resistor RON.

It will be appreciated that the PWM wave outputs a PWM1 waveform through the inverter 138 and outputs a PWM2 waveform on another path that does not pass through the inverter 138, and the waveform passes through the inverter 138 is opposite to the waveform that does not pass through the inverter 138.

In the embodiment, after activation of the boost circuit unit 131, PWM 2 is low in the first half cycle, and the PWM generating circuit subunit 134 is low and controls the first switch transistor Q4 and the third switch transistor Q6 to be turned on to charge the pump capacitor CE1. At this point, the PWM signal is output PWM 1 through the inverter 138 to high and controls the second switch transistor Q5 and the fourth switch transistor Q7 to be closed. In the second half cycle, the second switch transistor Q5 and the fourth switch transistor Q7 are turned on, the first switch transistor Q4 and the third switch transistor Q6 are closed, the third capacitor C5 is charged by the pump capacitor CE1, and the current required by the load is supplied, the voltage is continuously boosted to the voltage and current required by the battery management chip by controlling the PWM frequency and the duty cycle, and the charging current to the pump capacitor CE1 is controlled by the output feedback adjusting circuit to further control the output.

Among them, the third switch transistor Q6 is closed to charge the energy storage capacitor C5 by the pump capacitor CE1, providing the required electric quantity to the load. The energy storage capacitor C5 is the energy storage capacitor of the charge pump boost subunit, and provides current to the eighth resistor Rload. The feedback comparator Q3' is the feedback adjusted voltage output after boosting, and is realized by series voltage division of a high-precision first feedback resistor Rf1 and a second feedback resistor Rf2. The voltage at the inverting input terminal of the feedback comparator Q3' is Rf2 * Vout/(Rf1 + Rf2). When the voltage at the inverting input terminal of the feedback comparator Q3 'is less than the voltage at the output terminal of the sampling feedback unit 133, the feedback comparator Q3' sends a signal indicating that the output voltage is too low to the logic subunit 139, the logic subunit 139 adjusts the tuning resistor RON after the judgment process, and controls the charge pump boost subunit to boost the voltage so as to reach the target voltage.

When the voltage at the inverting input terminal of the feedback comparator Q3 'is greater than the voltage at the output terminal of the sampling feedback unit 133, the feedback comparator Q3' sends a signal indicating that the output voltage is too high to the logic subunit 139, the logic subunit 139 adjusts the tuning resistor RON after the judgment process, and controls the charge pump boost subunit to step down so as to reach the target voltage.

At present, the communication mode adopted by the common battery management chip is mainly a twisted-pair daisy-chain cable, and this wired communication mode using the twisted-pair daisy-chain cable needs to add an isolation device and an electromagnetic compatibility protection device at the communication terminal to ensure the reliable and stable communication of the vehicle in a complex interference environment. Secondly, when the twisted-pair daisy-chain cable wired communication mode synchronously monitors battery cell information, the requirements of serial transmission mode and bidirectional transmission will lead to delay in data reception and increased demand for timing processing in synchronous monitoring. Finally, the wired communication method involves the wiring harness and connectors, which is also a huge challenge for the reliability, stability and cost of the wiring harness connectors.

Therefore, as shown in FIG. 1, the first communication module 12 of the embodiment of the present disclosure adopts a first wireless communication unit, and by using the first wireless communication unit, wireless communication transmission of the battery management chip 1 is realized. Firstly, it reduces the isolation devices and protection devices required for the coupling interference of wire communication harness noise, which can improve the communication quality, ensure the correct transmission and interaction of data, and reduce the complexity of sampling board and more flexible application. Secondly, the communication mode of the first wireless communication unit is adopted, comparing with the wired communication mode using the twisted-pair daisy-chain cable, the wireless communication mode making the information interaction more flexible and convenient, realizing the natural time synchronization measurement, and supporting more synchronous induction functions. Furthermore, it can avoid the problem of battery information loss caused by wiring harness, and improve the safety of the whole vehicle. Finally, reducing complex wiring harnesses and connectors can reduce the weight and complexity of the whole vehicle, improve design flexibility, and make maintenance simpler and more convenient.

In some embodiments, as shown in FIG. 1, the first power module 13 is connected to the first wireless communication unit, and is used for supplying power to the first wireless communication unit. The first power supply module 13 supplies power to the first wireless communication unit to ensure normal communication of the first wireless communication unit.

In some embodiments, the first wireless communication unit includes at least one of a bluetooth, an RFID (Radio Frequency Identification) unit, an electromagnetic wave wireless communication unit, and an SparkLink communication unit. In other words, the first wireless communication unit may realize wireless communication by at least one of a bluetooth communication method, an RFID communication method, an electromagnetic wave communication method, and a SparkLink communication method, but is not limited to. It is understandable that the SparkLink communication method uses SparkLink technology for wireless communication. It is a short-distance communication technology that can be used to achieve wireless interconnection to carry data interaction and transmission in vehicle application scenarios. It has the advantages of ultra-low latency, ultra-high reliability, and precise synchronization.

In some embodiments, as shown in conjunction with FIGS. 1 and 6, the data processing module 11 includes a multiplexing switch module 110, a conversion module 111, a filtering module 112, and an arithmetic storage module 113. The multiplexing switch module 110 is connected to the battery cell data sampling module 10, and is used for selecting battery cell data. The conversion module 111 is connected to the multiplexing switch module 110, and is used for performing analog/digital or digital/analog conversion on the selected battery cell data to obtain digital information and/or analog information of the battery cell data. The filtering module 112 is connected to the conversion module 111, and is used for filtering out interference information in the digital information and/or analog information. The arithmetic storage module 113 is connected to the filtering module 112, and is used for arithmetic and storage of filtered digital information and/or analog signals.

In an embodiment, the battery cell data is processed by the multiplexing switch module 110, the conversion module 111, the filtering module 112, and the arithmetic storage module 113 to obtain the processed battery cell data, so as to transmit the battery cell data through the first wireless communication unit.

In some embodiments, as shown in FIG. 6, the battery cell data sampling module 10 includes at least one of the following: a voltage sampling module (VSM) for acquiring voltage data of the battery cell; a current sampling module (CSM) for acquiring power data of the battery cell; a temperature acquisition module (TAM) for acquiring temperature data of the battery cell; and the resistance sampling module (RSM) for acquiring the resistance data of the battery cell. By setting the corresponding sampling module to realize the acquisition of battery cell data.

In some embodiments, as shown in FIG. 6, the battery management chip 1 further includes an equalization module 14, and the equalization module 14 is connected to the battery cells, and is used for performing consistency processing on the voltages of the battery cells so that the difference between the voltage of the battery cell and the minimum voltage of the remaining battery cells is within a preset voltage range. It can be understood that by setting the equalization module 14, when the voltage consistency of the battery cells is abnormal, that is, when the voltage of a certain battery cell is high, the voltage of the battery cell is reduced by the equalization module 14, so that the difference between the voltage of the battery cell and the minimum voltage of the remaining battery cells is small, and the voltage consistency between the individual battery cells is guaranteed.

In some embodiments, as shown in FIG. 6, the battery management chip 1 further includes a clock module 15, and the clock module 15 is connected to the first power module 13 for determining the transmission and reception timing of battery cell data. By setting the clock module 15, the transmission and reception timing of the battery cell data is controlled so that the battery cell data is received and transmitted according to inherent timing sequence.

At present, the temperature monitoring of the battery pack, the chip, the environment, etc. mainly calculates and judges the temperature through the change of the resistance value of the temperature sensitive resistor. This scheme will cause the temperature information to be not timely enough because the change of the resistance value takes time, resulting in the early thermal fault and failure detection and monitoring. Thus, as shown in FIG. 6, in an embodiment of the present disclosure, the temperature acquisition module includes a temperature sensor. By disposing a temperature sensor in the temperature acquisition module to acquire the temperature data of the battery cell, compared with using a temperature-sensitive resistor, the temperature sensor responds more sensitively and quickly to the temperature data, thus greatly improving the temperature response processing speed.

In some embodiments, the temperature sensor is integrally disposed in the temperature acquisition module, thereby saving the arrangement space of the battery management chip 1 and saving costs.

The battery management chip 1according to an embodiment of the present disclosure, boosts the initial voltage output by the battery cell through the first power module, provides an operating voltage for the data processing module, ensures that the battery management chip can operate in a wide range of low voltages, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

A battery management system according to an embodiment of the present disclosure will be described below.

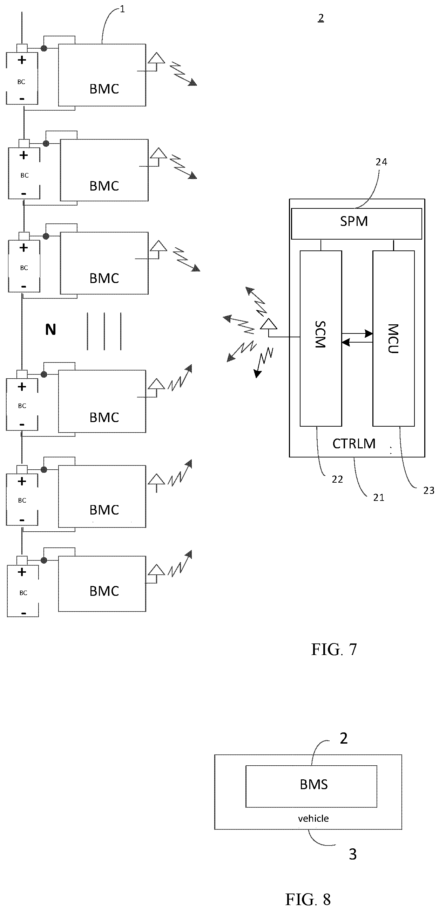

As illustrated in FIG. 7, the battery management system 2 according to an embodiment of the present disclosure includes at least one battery management chip 1 as described in the above embodiment; at least one battery cell (not shown) connected to at least one of the battery management chips in one-to-one correspondence; and a control module 21 communicating with the battery management chip 1.

The battery management system 2 according to an embodiment of the present disclosure, boosts the initial voltage output by the battery cell through the first power module, provides an operating voltage for the data processing module, ensures that the battery management chip can operate in a wide range of low voltages, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

In some embodiments, the control module 21 includes: a second communication module 22 communicating with the first communication module of the battery management chip 1; the micro-control unit 23 receiving the battery cell data transmitted by the battery management chip 1 through the second communication module 22, and transmitting a control signal to the battery management chip 1 through the second communication module 22, so that the battery management chip 1 can control battery cells connected thereto; the second power module 24 being connected to the micro-control unit 23 and being used for supplying power to the micro-control unit 23. One battery management chip 1 manages one battery cell, the control module 22 can perform data interaction processing with a plurality of battery management chips 1 at the same time, the control module 22 sends an effective operation instruction, and when the battery management chip 1 receives the instruction through wireless communication, it starts to acquire and monitor the battery cell data of a single battery cell, and then transmits it to the control module 21 through wireless communication for data analysis and processing, waiting for the next operation.

In some embodiments, the second communication module 22 includes a second wireless communication unit. Wireless communication can be realized between the first wireless communication unit and the second wireless communication unit, and more synchronous sensing functions are supported, so that the communication use is more free and flexible. Transmitting data through wireless communication is another major innovation in the twisted-pair daisy-chain wired communication method. Firstly, it reduces the isolation devices and electromagnetic compatibility protection devices required for the coupling interference of the wired communication harness noise. On the one hand, it reduces the complexity of the battery sampling board, on the other hand, the application is more flexible. Secondly, compared with twisted-pair daisy-chain serial wired communication, wireless communication makes information interaction more flexible and convenient, can naturally realize time synchronization measurement, can support more synchronous induction functions, and can avoid the problem of multi-string battery information loss in serial communication caused by wiring harness, thus improving the safety of the whole vehicle. Finally, the absence of complicated wiring harnesses and connectors in terms of structure can reduce the weight and complexity of the whole vehicle, improve the flexibility of design, and make maintenance simpler and more convenient.

In some embodiments, the second power module 24 is connected to the second wireless communication unit and is used for supplying power to the second wireless communication unit. The second power module is the workpiece of the second wireless communication unit to ensure the normal operation of the wireless communication unit.

A vehicle according to an embodiment of the present disclosure will be described below.

As illustrated in FIG. 8, the vehicle 3 according to the embodiment of the present disclosure includes the battery management system 2 as described in the above embodiment.

The vehicle 3 according to an embodiment of the present disclosure, boosts the initial voltage output by the battery cell through the first power module, provides an operating voltage for the data processing module, ensures that the battery management chip can operate in a wide range of low voltages, and correspondingly monitors one battery cell through one battery management chip. The first aspect does not need the battery management chip to face the high voltage generated by the multiple battery cells in series, avoids the battery cells from working under the high voltage to avoid unnecessary energy loss, thereby reducing process requirements for chip production while saving energy consumption, the second aspect can reduce the failure risk of the chip, avoids the one-time loss of data of the multiple battery cells and reduce the vehicle failure rate, and the third aspect can improve the flexibility of the battery management chip, reduces the use of a large number of wiring harnesses and connectors, reduces the complexity of the battery management chip, and improves the stability and reliability of the battery management chip.

In the description of the present specification, reference to the terms "one embodiment", "some embodiments", "illustrative embodiment", "examples", "specific examples", or "some examples" or the like means that a specific feature, structure, material, or characteristic described in connection with the embodiment or example is included in at least one embodiment or example of the present disclosure. In the present specification, illustrative expressions of the above terms do not necessarily refer to the same embodiments or examples.

Although embodiments of the present disclosure have been shown and described above, it can be understood by those of ordinary skill in the art that various changes, modifications, replacements, and variations may be made to the foregoing embodiments without departing from the principles and spirits of the present disclosure, the scope thereof being defined by the claims and equivalents thereof.

## Claims

1. A battery management chip (1), the battery management chip (1) is correspondingly connected to a single battery cell, the battery management chip (1) comprising:
a battery cell data sampling module (10), being used for acquiring battery cell data of the battery cell;
a data processing module (11), being connected to the battery cell data sampling module (10) and being used for processing the battery cell data;
a first communication module (12), being connected to the data processing module (11) and being used for transmitting the processed battery cell data to the control module;
a first power supply module (13), being connected to the battery cell and the data processing module (11) and being used for receiving an initial voltage output by the battery cell and performing a boost processing on the initial voltage to provide an operating voltage for the data processing module (11).

2. The battery management chip (1) according to claim 1, wherein the first power module (13) comprises:
a boost circuit unit (131), the boost circuit unit (131) being connected to the battery cell and being used for performing boost processing on an initial voltage output from the battery cell to obtain an initial target voltage.

3. The battery management chip (1) according to claim 2, wherein the first power module (13) further comprises:
an input filtering voltage stabilizing circuit unit (130), an input terminal of the input filtering voltage stabilizing circuit unit (130) being connected to a voltage output terminal of the battery cell and being used for reducing voltage ripple interference of the initial voltage output by the battery cell to output a DC voltage.

4. The battery management chip (1) according to claim 2 or 3, wherein the first power module (13) further comprises:
an output filtering voltage stabilizing circuit unit (132), the output filtering voltage stabilizing circuit unit (132) being connected to the boost circuit unit (131) and being used for performing filtering and stabilizing processing on the initial target voltage to obtain a target voltage and outputting the target voltage to provide an operating voltage for the data processing module (11).

5. The battery management chip (1) according to claim 4, wherein the first power module (13) further comprises:
a sampling feedback unit (133), the sampling feedback unit (133) being connected to the output filtering voltage stabilizing circuit unit (132) and the boost circuit unit (131) and being used for acquiring a voltage value of the target voltage and feeding back the voltage value of the target voltage to the boost circuit unit (131).

6. The battery management chip (1) according to claim 5, wherein,
the boost circuit unit (131) further configured to receive the voltage value of the target voltage and adjust the boost action based on the voltage value of the target voltage, so that the initial target voltage output after adjustment is filtered and stabilized by the output filtering voltage stabilizing circuit unit (132), and the output target voltage is in a preset voltage range.

7. The battery management chip (1) according to claim 5 or 6, wherein the boost circuit unit (131) comprises:
a PWM generating circuit subunit (134), a first terminal of the PWM generating circuit subunit (134) being connected to an output terminal of the input filtering voltage stabilizing circuit unit (130), a second terminal of the PWM generating circuit subunit (134) being grounded, and a third terminal of the PWM generating circuit subunit (134) being used for outputting a PWM signal; and
a charge pump boost subunit (135), a first terminal of the charge pump boost subunit (135) being connected to the third terminal of the PWM generating circuit subunit (134), and being used for adjusting the frequency and duty cycle of the PWM signal in real time until the initial target voltage being obtained.

8. The battery management chip (1) according to claim 7, wherein the PWM generating circuit subunit (134) comprises:
an energy storage subunit (C1), one terminal of the energy storage subunit (C1) being connected to the output terminal of the input filtering voltage stabilizing circuit unit (130), and the other terminal of the energy storage subunit (C1) being grounded;
a waveform generating subunit (136), a first terminal of the waveform generating subunit (136) being connected to the output terminal of the input filtering voltage stabilizing circuit unit (130), and a second terminal of the waveform generating subunit (136) being grounded;
a voltage follower circuit (137), a first terminal of the voltage follower circuit (137) being connected to the output terminal of the input filtering voltage stabilizing circuit unit (130), and a third terminal of the voltage follower circuit (137) being ground;
a first comparator (Q1), a positive-phase input terminal of the first comparator (Q1) being connected to the first terminal of the waveform generating subunit (136); a second comparator (Q2), a positive-phase input terminal of the second comparator (Q2) being connected to the third terminal of the voltage follower circuit (137), an inverting input terminal of the second comparator (Q2) being connected to an inverting input terminal of the first comparator (Q1), and an output terminal of the second comparator (Q2) being connected to the first terminal of the charge pump boost subunit (135);
a charge/discharge capacitor (C2), one terminal of the charge/discharge capacitor (C2) being connected to the inverting input terminal of the first comparator (Q1) and the inverting input terminal of the second comparator (Q2), and the other terminal of the charge/discharge capacitor (C2) being grounded; and
a duty cycle adjustment resistor (RE1), one terminal of the duty cycle adjustment resistor (RE1) being connected to the output terminal of the input filtering voltage stabilizing circuit unit (130), and the other terminal of the duty cycle adjustment resistor (RE1) being connected to a second terminal of the voltage follower circuit (137).

9. The battery management chip (1) according to claim 8, wherein the waveform generating subunit (136) comprises:
a voltage adjusting subunit, a first terminal of the voltage adjusting subunit being connected to the output terminal of the input filtering voltage stabilizing circuit unit (130), and a second terminal of the voltage adjusting subunit being grounded;
a charge/discharge subunit, one terminal of the charge/discharge subunit being connected to an output terminal of the first comparator (Q1), and the other terminal thereof being connected to one terminal of the charge/discharge capacitor (C2).

10. The battery management chip (1) according to claim 9, wherein the voltage adjusting subunit comprises:
a first resistor (R1), one terminal of the first resistor (R1) being connected to the output terminal of the input filtering voltage stabilizing circuit unit (130);
a second resistor (R2), one terminal of the second resistor (R2) being connected to the output terminal of the input filtering voltage stabilizing circuit unit (130);
a third resistor (R3), one terminal of the third resistor (R3) being connected to the other terminal of the first resistor (R1), and the other terminal of the third resistor (R3) being connected to the other terminal of the second resistor (R2); and
a fourth resistor (R4), one terminal of the fourth resistor (R4) being connected to the positive-phase input terminal of the first comparator (Q1), and the other terminal of the fourth resistor (R4) being grounded.

11. The battery management chip (1) according to claim 9 or 10, wherein the charging/discharging subunit includes a fifth resistor (R5).

12. The battery management chip (1) according to any one of claims 8 to 11, wherein the voltage follower circuit (137) comprises:
a voltage dividing subunit, one terminal of the voltage dividing subunit being connected to the other terminal of the duty cycle adjustment resistor (RE1), and the other terminal of the voltage dividing subunit being grounded;
a voltage difference output unit, a first terminal of the voltage difference output unit being connected to the output terminal of the input filtering voltage stabilizing circuit unit (130), and a second terminal of the voltage difference output unit being connected to one terminal of the voltage dividing subunit.

13. The battery management chip (1) according to claim 11 or 12, wherein the voltage difference output unit comprises:
a seventh resistor (R7), one terminal of the seventh resistor (R7) being connected to one terminal of the duty cycle adjustment resistor (RE1);
a triode (Q3), a base electrode of the triode (Q3) being connected to the other terminal of the duty cycle adjustment resistor (RE1) and a collector electrode of the triode (Q3) being connected to the other terminal of the seventh resistor (R7);
a voltage stabilizing energy storage capacitor, one terminal of the stabilizing energy storage capacitor is connected to an emitter electrode of the triode, and the other terminal of the stabilizing energy storage capacitor is grounded.

14. The battery management chip (1) according to any one of claims 8 to 13, wherein the charge pump boost subunit (135) comprises:
a filtering voltage stabilizing capacitor (C4), one terminal of the filtering voltage stabilizing capacitor (C4) being connected to the output terminal of the input filtering voltage stabilizing circuit unit (130), and the other terminal of the filtering voltage stabilizing capacitor (C4) being grounded;
a feedback adjusting subunit, a first terminal of the feedback adjusting subunit being connected to one terminal of the filtering stabilizing capacitor (C4), and a second terminal of the feedback adjusting subunit being grounded;
a charge/discharge control subunit, a first terminal of the charge/discharge control subunit being connected to one terminal of the filtering voltage stabilizing capacitor (C4), and a second terminal of the charge/discharge control subunit being connected to the output terminal of the second comparator (Q2);
an energy storage capacitor (C5), one terminal of the energy storage capacitor (C5) being connected to a third terminal of the charge/discharge control subunit, and the other terminal of the energy storage capacitor (C5) being grounded, and the energy storage capacitor (C5) being used for charging when a second switch transistor (Q5) and a fourth switch transistor (Q7) are turned on.

15. The battery management chip (1) according to claim 14, wherein the charge/discharge control subunit comprises:
a first switch transistor (Q4), a gate electrode of the first switch transistor (Q4) being connected to the output terminal of the second comparator (Q2);
an inverter (138), an input terminal of the inverter (138) being connected to the output terminal of the second comparator (Q2);
a second switch transistor (Q5), a gate electrode of the second switch transistor (Q5) being connected to an output terminal of the inverter (138);
a third switch transistor (Q6), a drain electrode of the third switch transistor (Q6) being connected to a source electrode of the second switch transistor (Q5) and a gate electrode of the third switch transistor (Q6) being connected to the gate electrode of the first switch transistor (Q4);
a fourth switch transistor (Q7), a source electrode of the fourth switch transistor (Q7) being connected to a source electrode of the third switch transistor (Q6), and a gate electrode of the fourth switch transistor (Q7) being connected to the output terminal of the inverter (138);
a pump capacitor (CE1), one terminal of the pump capacitor (CE1) being connected to the drain electrode of the second switch transistor (Q5), and the other terminal of the pump capacitor (CE1) being connected to the source electrode of the fourth switch transistor (Q7), and the pump capacitor (CE1) being used for charging when the first switch transistor (Q4) and the third switch transistor (Q6) are turned on.

16. The battery management chip (1) according to claim 14 or 15, wherein the feedback adjusting subunit comprises:
a tuning resistor (RON), a first terminal of the tuning resistor (RON) being connected to the output terminal of the input filtering voltage stabilizing circuit unit (130), and a second terminal of the tuning resistor (RON) being connected to the first terminal of the charge/discharge control subunit;
a first feedback resistor (Rf1), one terminal of the first feedback resistor (Rf1) being connected to one terminal of the energy storage capacitor (C5);
a second feedback resistor (Rf2), one terminal of the second feedback resistor (Rf2) being connected to the other terminal of the first feedback resistor (Rf1), and the other terminal of the second feedback resistor (Rf2) being grounded;
an eighth resistor (Rload), one terminal of the eighth resistor (Rload) being connected to one terminal of the first feedback resistor (Rf1), and the other terminal of the eighth resistor (Rload) being connected to the other terminal of the second feedback resistor (Rf2);
a feedback comparator (Q3'), an inverting input terminal of the feedback comparator (Q3') being connected to the other terminal of the first feedback resistor (Rf1), and a positive-phase input terminal of the feedback comparator (Q3') being connected to an output terminal of the sampling feedback unit (133), and
a logic subunit (139), an input terminal of the logic subunit (139) being connected to an output terminal of the feedback comparator (Q3') and an output terminal of the logic subunit (139) being connected to a adjusting terminal of the tuning resistor (RON).

17. The battery management chip (1) according to any one of claims 1 to 16, wherein the first communication module (12) comprises a first wireless communication unit.

18. The battery management chip (1) according to claim 17, wherein the first power module (13) is connected to the first wireless communication unit and is used for supplying power to the first wireless communication unit.

19. The battery management chip (1) according to any one of claims 2 to 16, wherein the data processing module (11) comprises:
a multiplexing switch module (110) connected to the battery cell data sampling module (10) and used for selecting the battery cell data;
a conversion module (111) connected to the multiplexing switch module (110) and used for performing analog/digital or digital/analog conversion on the selected battery cell data to obtain digital information and/or analog information of the battery cell data;
a filtering module (112) connected to the conversion module (111) and used for filtering out interference information in the digital information and/or analog information; and
an arithmetic storage module (113) connected to the filtering module (112) and used for arithmetic and storage of the filtered digital information and/or analog signals.

20. The battery management chip (1) according to any one of claims 1 to 19, wherein the battery cell data sampling module (10) comprises at least one of the following:
a voltage sampling module for acquiring voltage data of the battery cell;
a current sampling module for acquiring power data of the battery cell;
a temperature acquisition module for acquiring temperature data of the battery cell; and
a resistance sampling module for acquiring resistance data of the battery cell.

21. The battery management chip (1) according to any one of claims 1 to 20 further comprising:
an equalization module (14) connected to the battery cell and used for performing consistency processing on the voltage of the battery cell so that the difference between the voltage of the battery cell and the minimum voltage of the remaining battery cells is within a preset voltage range.

22. The battery management chip (1) according to claim 20, wherein the temperature acquisition module comprises a temperature sensor, the temperature sensor being integrally disposed in the temperature acquisition module.

23. A battery management system, comprising:
at least one battery management chip (1) according to any one of claims 1-22;
at least one battery cell connected to at least one of the battery management chip (1) in one-to-one correspondence;
a control module (21) communicating with the battery management chip (1).

24. The battery management system according to claim 23, wherein the control module (21) comprises:
a second communication module (22), the second communication module (22) communicating with a first communication module (12) of the battery management chip (1);
a micro-control unit (23) receiving battery cell data transmitted by the battery management chip (1) through the second communication module (22), and transmitting a control signal to the battery management chip (1) through the second communication module (22), so that the battery management chip (1) can controls the battery cells connected thereto; and
a second power module (24), the second power module (24) being connected to the micro-control unit (23) and used for supplying power to the micro-control unit (23).

25. The battery management system according to claim 24, wherein the second communication module (22) comprises a second wireless communication unit, the second power module (24) being connected to the second wireless communication unit and used for supplying power to the second wireless communication unit.

26. A vehicle (3), wherein the vehicle comprises: the battery management system according to any one of claims 23-25.
